# EUROPEAN PATENT APPLICATION

(11) **EP 0 887 859 A2**
(43) Date of publication of application: **30.12.1998**
(21) Application number: 98304456.1
(22) Date of filing: 05.06.1998
(51) Int. Cl.: H01L 23/525

(54) **Integrated circuits with metallic fuses and method**

(30) Priority: 23.06.1997 KR 9726418
(71) Applicant: Samsung Electronics Co., Ltd., Suwon-City, Kyungi-do (KR)
(72) Inventor: Park, Yong, Seocho-gu, Seoul (KR); Lee, Soo-Cheol, Kangnam-gu, Seoul (KR)
(74) Representative: Ellis, Kate, Dr.

(57) **Abstract**

An integrated circuit is provided having a metal fuse link severable by a laser beam which may enhance the long term reliability of metal interconnects and the fuse link. The integrated circuit includes an insulating layer formed on a semiconductor substrate; at least one pair of metal wiring layers formed on the insulating layer and preferably having ends opposite to each other; and a barrier metal fuse layer, preferably formed on the upper surfaces of the metal wiring layers, on the side surfaces of the opposing ends and in between the ends, to define a fuse link severable by irradiation with laser beam energy, the fuse layer being less susceptible to electromigration than the metal wiring layers and/or more absorptive of irradiating laser beam energy than the metal wiring layers.

## Description

### Background of the Invention

The present invention relates to integrated circuits and a process for manufacturing integrated circuits, and more particularly to those having fusible metallic fuse links.

Semiconductor integrated circuits frequently include fusible conductive links, i.e. fuses, which may be removable by irradiation with laser beams. For example, in semiconductor memories such as dynamic random access memories (DRAMs), static random access memories (SRAMs), electrically erasable and programmable read only memories (EEPROMs) and so on, defective memory cells can be replaced by blowing fuses associated with them and allowing spare memory cells to be selected instead of the defective memory cells. Such replacement techniques, i.e. redundancy techniques, may be accomplished by blowing fuses to inactivate a row or column line, or a memory block of defective memory cells and to activate a row or column line, or a memory block of spare memory cells upon receipt of address signals designating the defective memory cells, thereby enhancing the fabrication yield of semiconductor memories. These redundancy techniques are disclosed in U.S. Pat. Nos. 4,794,568, 4,829,480 and 5,297,085, all of which are assigned to the present assignee.

In semiconductor memory chips such as DRAM chips, each of these may be embedded with electronic circuit devices for performing various modes of operation such as a static column mode, page mode, nibble mode and the like. If users require one of those modes of operation, fuses may be blown to inactivate the other unwanted ones Fuses may also be blown to select desired logic circuits in semiconductor integrated circuits.

Recent integrated circuits use multilevel metallization techniques including at least two or more stacked interlevel insulating layers and metal interconnection layers formed on each interlevel insulating layer in order to integrate in higher density on a given chip area. The metal interconnection layers are interconnected with circuit devices on a semiconductor substrate, or with other interconnection layers, through metallic plugs formed in via holes in the layers. Conventionally, fuses are formed between an uppermost interlevel insulating layer and an underlying interlevel insulating layer which is contiguous with the uppermost layer. The uppermost interlevel insulating layer, which is commonly called a passivating layer, has grooves so that the fuses may easily be cut by the application of laser beam energy. Fuses of polysilicon have been used as disclosed in U.S. Pat. No. 5,241,212. However, production of polysilicon fuses is not simple when fabricating integrated circuits using multilevel metallization techniques. The manufacturing cost is therefore increased.
A technique for metal fuses such as aluminum fuses is disclosed in U.S. Pat. No. 5,185,291. In this document, a first layer of aluminum material is deposited on a dielectric surface and then etched locally to form holes or windows at one or several points selected for fusing, exposing the underlying dielectric. A second layer of aluminum material is deposited and then etched to produce a desired conductive path passing through such points. Thus, laser programmable fuse links have locally reduced thickness at those points. However, the glassy surface of the aluminum fuse links absorb only a small amount of the impinging laser energy. This means that high energy lasers are required to severe the fuses. Moreover, a large amount of optical reflection of high laser energy from uneven surfaces, such as surfaces having hillocks or spikes, of fuse links or conductive paths can damage an interlevel insulating layer surrounding the fuse links. Such damages may be extensive cracks reaching adjacent metal interconnects or fuse links through the interlevel insulating layer from the chip outside. When these interconnects or fuse links are so exposed, they become subject to corrosion which can subsequently result in their breaking. Thus, it is desired that the fuses can be readily severed at lower energy levels of laser beams.

On the other hand, it is required that metal fuse links and interconnects be simultaneously formed on the same insulating layer in a high density integrated circuit. When the metal interconnects are disposed with narrow spacings between them, such as submicron or subhalf-micron spacings, it is difficult to make fine etching mask patterns for forming the metal interconnects due to optical light reflection into the photoresist layer from the highly reflective surface of the second aluminum layer of the prior art. The failure of fine etching mask patterns can result in either opening or shorting of the interconnects.

In particular, the widths of the interconnects can be smaller than the desired width due to the failure of the fine etching mask patterns. In this case, during the operation of the integrated circuits, higher current densities generated by forcing the same current through the smaller interconnects could result in increased electromigration of aluminum atoms, thereby causing the interconnects to be opened. The fuse links are also in the same situation as the interconnects. The reduced aluminum thickness at each fuse portion is apt to be susceptible to electromigration. Thus, it is desired to enhance the long term reliability of interconnects and fuse links.

It is accordingly a preferred object of the present invention to seek to provide an integrated circuit having a metal fuse link, adapted to be blown by a laser beam, which enhances the long term reliability of the metal fuse link.

It is another preferred object of the present invention to seek to provide an integrated circuit having a metal fuse link adapted to be blown by the irradiation with a low energy laser.

It is a further preferred object of the present invention to seek to provide an integrated circuit having a plurality of closely disposed metal interconnects at least one of which includes a fuse portion wherein fine patterning of the metal interconnects is possible.

### Summary of the Invention

According to the invention there is provided an integrated circuit comprising:
a first insulating layer formed on a semiconductor substrate;
at least one pair of metal wiring layers formed on said insulating layer and spaced apart; and
a metallic fuse layer formed to electrically connect said metal wiring layers, to define a fuse link severable by irradiation with a laser beam, in which the metallic fuse layer comprises a barrier metal less susceptible to electromigration than said metal wiring layers and/or more absorptive of irradiating laser beam energy than the metal wiring layers.

In a further aspect there is provided a process of manufacturing an integrated circuit comprising a plurality of metal interconnections on an insulating layer formed on a semiconductor substrate, in which at least one of said metal interconnections includes a fuse link severable by a laser beam, comprising the steps of :
forming a metal interconnection layer on a first insulating layer;
etching a selected portion of said metal interconnection layer for providing at least one pair of metal wiring layers being spaced apart;
forming a metallic fuse layer of a barrier metal on said etched portion to electrically connect the metal wiring layers; and
etching to form said metal interconnections including defining said fuse link;
   in which the metallic fuse layer comprises a barrier metal less susceptible to electromigration than said wiring layers and/or more absorptive of irradiating laser beam energy than the metal wiring layers.

Preferably, the metallic fuse layer is formed over end surfaces of the metal wiring layers.

Preferably, the end surfaces of the metal wiring layers are opposite each other.

Preferably, the metallic fuse layer is formed on the upper surfaces of the metal wiring layers.

Preferably, the metallic fuse layer comprises a layer of TiN and/or TiW.

Preferably, said two metal wiring layers each comprise, or consist of, a layer of pure aluminum or aluminum alloy.

Preferably, said two metal wiring layers each is formed of a barrier metal layer and a metal interconnection sublayer formed on the barrier metal layer.

Preferably, said barrier metal layer is a TiN layer, TiW layer or a Ti layer with a TiN layer formed on the Ti layer and/or said metal interconnection sublayer is an aluminium or aluminum alloy layer.

Preferably, an interlevel second insulating layer is formed on said first insulating layer and on said fuse layer, and a groove is formed in said interlevel insulating layer exposing at least a portion of said fuse link.

Preferably, the size of said groove is larger than the diameter of said laser beam.

Preferably, a plurality of upper metal interconnections is formed on said interlevel second insulating layer for connecting to said underlying fuse layer, and a protection layer is formed covering said exposed fuse link and said upper metal interconnections.

Preferably, said protection layer is a silicon-nitride layer.

Preferably, a space separating the two metallic wiring layers is wider, in a direction generally perpendicular to a line drawn between the ends of the two metallic layers, than the width of the metallic fuse layer.

Preferably, an integrated circuit portion is formed on a semiconductor substrate;
the first insulating layer is formed on said integrated circuit portion;
a plurality of metal wiring layers is formed at submicron or subhalf-micron spacing on said insulating layer for connecting to said integrated circuit portion, at least one pair forming said pair of metal wiring layers being spaced apart and having opposing ends for providing a fuse link severable by irradiation with a laser beam;
   whereby the barrier metal is less reflective of optical light than the metal wiring layers.

Preferably, at least one fuse link is severed.

In a further aspect there is provided a process for severing a fuse link of an integrated circuit according to the invention comprising severing the fuse link with a laser beam of which the barrier metal is more absorptive than the metal wiring layers.

Preferably, there is provided an integrated circuit including: an insulating layer formed on a semiconductor substrate; two metal wiring layers separately formed on the insulating layer and having ends opposite to each other; and a metallic fuse layer formed on the upper surfaces of the metal wiring layers, on the side surfaces of the opposing ends and therebetween to define a fuse link severed by the irradiation of a laser beam energy, for preventing electromigration of the metal wiring layers and absorbing the irradiated laser beam energy.

In a further aspect there is further provided an integrated circuit comprising: an integrated circuit portion formed on a semiconductor substrate; an insulating layer formed on the integrated circuit portion; a plurality of metal wiring layers densely formed on the insulating layer for connecting to the integrated circuit portion, at least one pair of the metal wiring layers being spaced apart and having opposing ends for providing a fuse link severable by irradiation from a laser beam; a metallic fuse layer formed on the upper surfaces of the metal wiring layers, on the surfaces of the ends and therebetween, for preventing electromigration of the metal wiring layers, absorbing the irradiated laser beam energy and reducing an optical light reflection of the metallic fuse layer to a photoresist; and an interlevel insulating layer formed on the insulating layer and the fuse layers, and having a groove formed therein to expose at least a portion of the fuse link.

In a further aspect there is still further provided a process of manufacturing a plurality of metal interconnections on an insulating layer formed on a semiconductor substrate, wherein at least one of the metal interconnections includes a fuse link adapted to be blown by a laser beam, including the steps of : forming a metal interconnection layer on the insulating layer; etching a selected portion of the metal interconnection layer for providing the fuse link; forming a fuse layer of either TiN or TiW on the metal interconnection layer and the etched portion; and etching to form the metal interconnections including the fuse link.

### Brief Description of the Drawings

The invention will now be described by way of example only with reference to the following figures.

FIGS. 1 to 5 are greatly enlarged perspective views illustrating the processing steps for a fusible metallic fuse link in accordance with one embodiment of the present invention.

FIG. 6 is a cross-sectional view of the finished structure taken along a line perpendicular to the direction of the length of the fuse link of FIG. 5.

FIG. 7 is a greatly enlarged cross-sectional view illustrating the insulating layer with the metal interconnect and plug connected to the active element formed on the semiconductor substrate in accordance with one embodiment of the present invention.

FIG. 8 is a greatly enlarged perspective view illustrating the processing step of the fuse link and a plurality of metal interconnects in accordance with another embodiment of the present invention.

FIG. 9 is a cross-sectional view of the finished structure taken along a line perpendicular to the direction of the length of the fuse link of FIG. 8.

### Detailed Description of the Preferred Embodiments

Metal interconnects including metallic fuse links in an integrated circuit will be explained in detail in accordance with the present invention. In the following description, numerous specific details are set forth such as specific dimensions, thicknesses, etc., in order to provide a thorough understanding of the present invention. It will be obvious to those skilled in the art, however, that the invention may be practised without these specific details. In other instances, well-known processes have not been described in detail in order not to unnecessarily obscure the present invention. It should be also noticed that in the drawings, like numerals represent layers of like material or like elements.

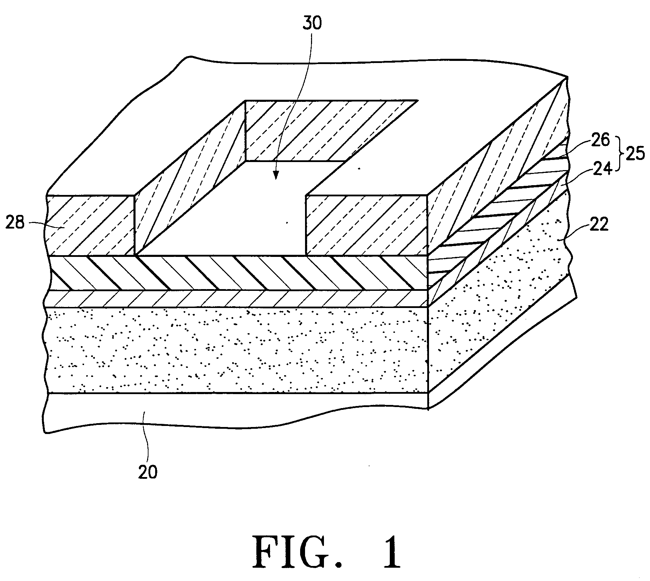

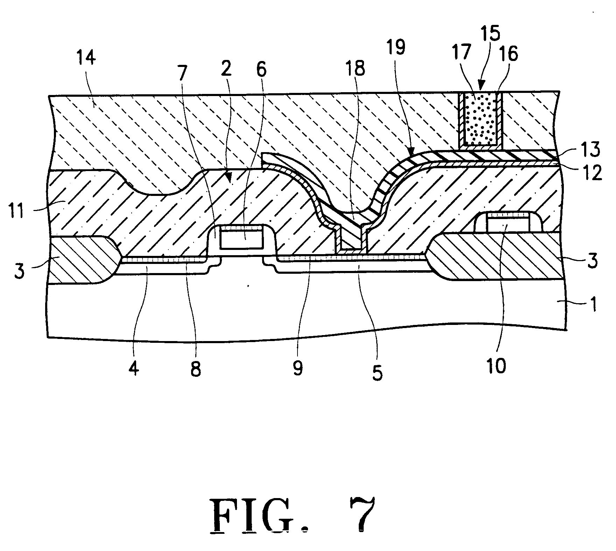

In FIG. 1, there is illustrated an insulating layer 22 of dielectric covering one face of a substrate 20, which may be monocrystalline silicon or other appropriate semiconducting material. The substrate 20 may include appropriately doped well regions used to enable the formation of CMOS or BICMOS. An integrated circuit portion including active elements such as field effect transistors, bipolar transistors or their combination is formed on the appropriately doped substrate 20. Metal interconnects may be formed on the insulating layer 22 in order to be connected with the integrated circuit portion as will be described later. The insulating layer 22 may include multilevel metal interconnects comprising a plurality of interlevel insulating layers, metal interconnects formed on each interlevel insulating layer, and metal plugs formed in the interlevel insulating layers in order to couple upper and lower metal interconnects on each interlevel insulating layer. As one example, a portion of the insulating layer is illustrated in FIG. 7, in which a two-level metal interconnect is formed on the substrate having active elements formed on it.

In FIG. 7, there is illustrated an n-channel field effect transistor 2 isolated by field oxide regions 3 on a p-type well region 1. A gate electrode 6 of polycide is formed over a channel region between source and drain regions 4 and 5 which are contiguous with field oxide regions 3. Refractory metal silicide layers 8 and 9, for example, titanium silicide TiSi₂ layers, are formed on source and drain regions 4 and 5 between both side walls 7 of the gate electrode 6 and field oxide regions 3 by a conventional silicide processing technique. An electrode layer 10 of prolicide is formed on the field oxide region 3. A first interlevel insulating layer 11, such as a tetraethyl orthosilicate(TEOS) oxide film, covers the active elements, field oxide regions 3 and the electrode layer 10.

A via hole 18 passing through the first inter-insulating layer 11 is formed to expose the TiSi₂ layer 9. Titanium nitride(TiN) and aluminum (Al) are stacked in turn on surfaces of the first interlevel insulating layer 11 and side walls and the bottom of the via hole 18 by way of sputtering and a metal interconnection layer 19 is then patterned by a photolithographic process. The TiN layer 12 serves as a barrier metal layer preventing the transport of overlying aluminum to the silicide layer 9.

A second interlevel insulating layer 14 of spin-on glass(SOG) is formed on the interconnection layer 19 and the exposed interlevel insulating layer 11 for its planarization. TEOS oxide layer or CVD SiO₂ layer instead of the SOG layer may be used and its planarization may be accomplished by a chemical mechanical polishing(CMP) process.

After the formation of a via hole for coupling to the Al layer 13, a plug made of a TiN layer 16 on the side walls and the bottom of the via hole filled with a layer 17 of aluminum or tungsten(W) may be formed by a conventional sputtering or CVD and etch-back processes. Tungsten is preferably used as plug filling material for minimization of electromigration.

The multilevel metallization scheme may be accomplished by repetitively stacking layers comprised of the interlevel insulating layer 14, plug 15 and metal interconnection layers 19 in such a manner that the metal interconnection layers are in contact with corresponding plugs. Even though the simplified substrate 20 and insulating layer 20 are illustrated in the drawings for the convenience, it is obvious to those skilled in the art that an insulating layer 22 employing the multilevel metallization scheme may be used.

Returning again to FIG.1, a metal interconnection layer 25 comprises a barrier metal layer 24 and a metal layer 26 which are stacked on the insulating layer 25. If needed, a single metal layer 26 may be used as the metal interconnection layer 25. The material of the barrier metal layer 24 may be TiW or TiN, but TiN is preferable.

In the present embodiment, the TiN barrier metal layer 24 is deposited to a thickness of between about 600 Å and 1200 Å by reactive sputtering from a titanium target at a substrate temperature of about 100°C in an atmosphere of argon gas flowing at a rate of about 25 SCCM and nitrogen gas flowing at a rate of about 105 SCCM. Pressure is maintained in a range between 10⁻⁸ Torr and 10⁻⁹ Torr prior to glow discharge and at about 4 milliTorr during the discharge.

The barrier metal layer 24 may be a bilayer of Ti and TiN. In this case, a Ti metal layer is deposited to a thickness of between about 200 Å and 400 Å from a Ti target in an atmosphere of argon gas by sputtering. Then, the TiN layer is deposited in situ to a thickness of between about 500 Å and 700 Å in the same manner as described above.

The Ti layer serves to lower the electrical contact resistance for the underlying plug filling metal such as tungsten or aluminum.

After deposition of the barrier metal layer 24, a metal blanket layer 26 is deposited on the barrier metal layer 24. In a preferred embodiment of the present invention, the material of the metal layer 26 is an aluminum alloy containing small percentages of copper(Cu), for example, approximately 0.5 % Cu and approximately 0.2% Si, in order to alleviate electromigration of aluminum. However, pure aluminum or one of aluminum alloys containing small percentages of either silicon or copper may be used.

In a preferred embodiment of the present invention, the metal layer 26 is successively deposited to a thickness between approximately 1µm to 1.5µm without breaking the vacuum in the same chamber after deposition of the barrier metal layer 24.

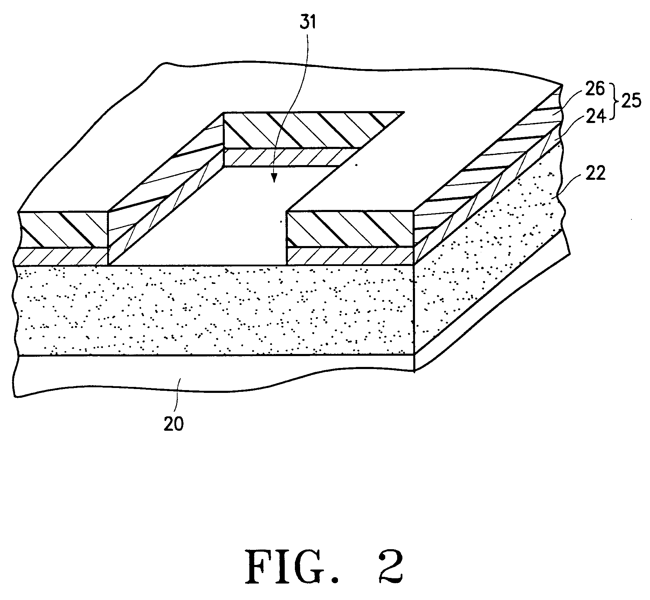

After the deposition of the metal layer 26, a photoresist is laid down. Then an etching window 30 exposing the surface of the underlying metal layer 26 is formed in the photoresist layer 28. The exposed metal layer and its underlying barrier metal layer are isotropically or anisotropically etched through the etching window 30 so as to expose the surface of the underlying insulating layer 22 by a known reactive ion etching technique, using the photoresist layer 28 as a mask. For example, anisotropic etching of the aluminum alloy may be performed by using a gas mixture of halide and halogen, such as boron trichloride and chlorine, while the isotropical or tapered etching thereof may be accomplished by a gas mixture of CHF₃ and Cl₂. The TiN layer 24 may be etched by a CHF₃-O₂ gas mixture. After etching through the etching window 30, the photoresist layer 28 is removed. The resulting structure following anisotropical etching is illustrated in FIG.2.

As illustrated in FIG.2, it should be noted that a groove 31 passing through the metal interconnection layer 25 is formed at a position where the fuse is to be formed. The size of the groove 31 is approximately 7.2 x 7.2µm².

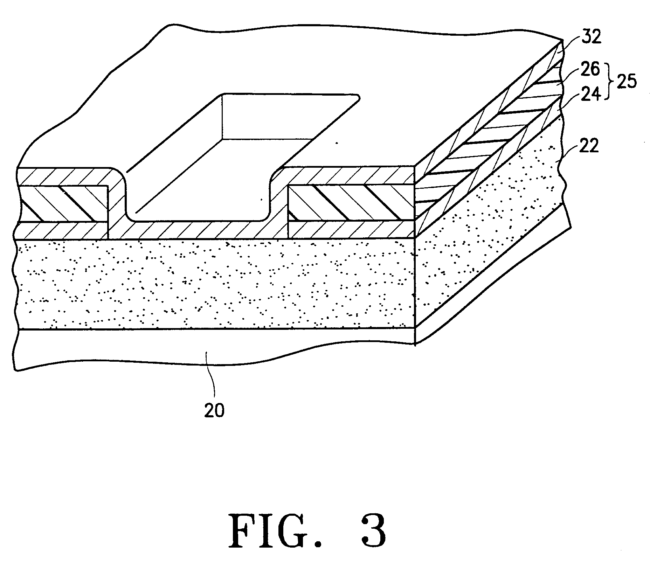

In FIG.3 a fuse layer 32 is sputter deposited on surfaces of the metal interconnection layer 25 and its side walls and the exposed insulating layer 32. In the present invention, the fuse layer 32 is of a metal serving as a barrier layer preventing the electromigration of aluminum atoms. Preferably it also acts as an antireflection layer minimizing the optical light reflection from the highly reflective aluminum layer and also preferably an absorptive layer absorbing the focused laser energy. Such a layer of metal may be of TiN or TiW. Though a TiW layer has lower electrical resistance than a TiN layer, the optical reflection index of a TiW layer is relatively higher than that of a TiN layer. In the present embodiment, even though a TiN layer is employed as the fuse layer 32, it should be appreciated that the use of TiW layer is not excluded.

The TiN fuse layer 32 is deposited to a thickness of between 250 Å and 500 Å. Since the aspect ratio (ratio of width to height) has a low value, a continuous TiN layer may be adhesively deposited on the vertical side walls of metal layer 26 and barrier metal layer 24. The deposition of preferably a continuous TiN layer may be accomplished by the isotropical or tapered etching as described above. Prior to the deposition of the fuse layer 32, it is important that a cleaning process and a process removing nature oxide from the aluminum surface is performed to enhance adhesion of TiN to the metal blanket layer 26. Such processes may be performed by back-sputtering or reactive ion sputtering prior to the sputtering of TiN.

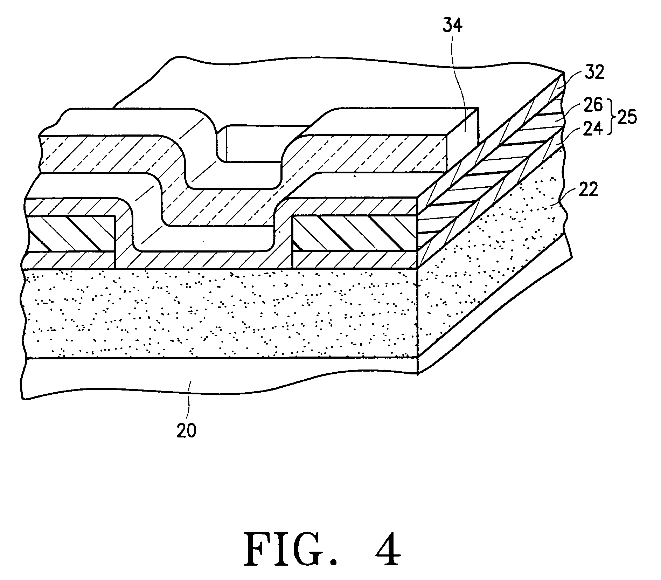

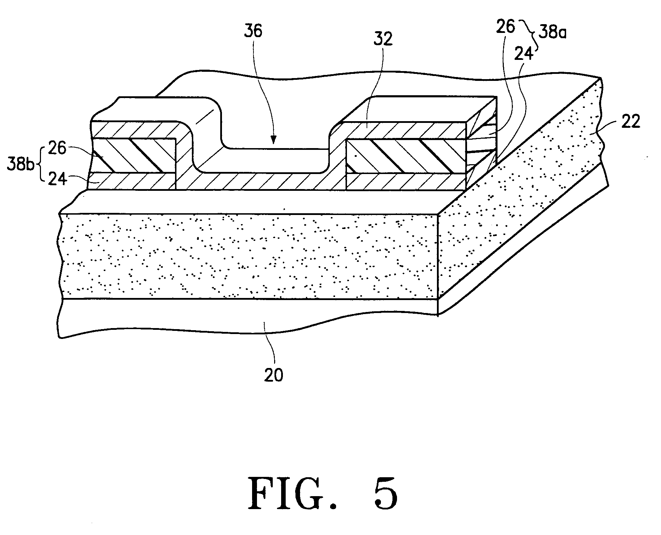

A mask layer 34 of photoresist is formed on the fuse layer 32 by a conventional photolithographic process as shown in FIG. 4. The width of the mask layer 34 is approximately 2.5 µm. The width of the mask layer 34 is narrower than that of the groove 31 so as to form a fuse link irrespective of any misalignment of the mask pattern. The fuse layer 32, blanket metal layer 26 and barrier metal layer 24 are anisotropically etched in turn, using the mask layer 34 as an etching mask. The mask layer 34 is then removed. Consequently, as shown in FIG.5, the fuse link 36 is defined as a fuse layer 32 connecting two spaced metal wiring layers 38a and 38b each made of the metal interconnection layer 25. The deposited TiN fuse layer 32 adheres well onto the upper surfaces of the metal wiring layers 38a and 38b, side wall surfaces of opposing ends of the layers 38a and 38b, and the exposed insulating layer 22 in between. Thus, the TiN layers 24 and 32 covering upper and lower surfaces and side wall end surfaces of the aluminum layer 26 may prevent electromigration of aluminum which is forced by large current densities. The thinner TiN fuse layer at the fuse portion (or fuse link) 36 is readily blown by the application of a low laser energy.

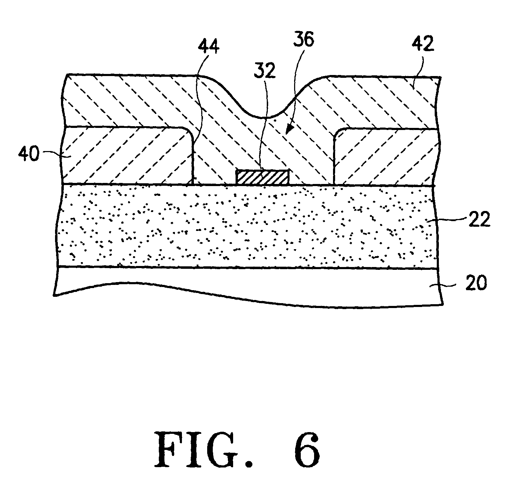

After the formation of the fuse link 36, a blanket interlevel insulating layer of doped SiO₂ such as TEOS or Phosphosilicate glass is deposited to a thickness of approximately 4,000 Å by a conventional CVD technique. A plug filled with aluminum or tungsten, as mentioned above, is formed in the interlevel insulating layer to be connected with one of the underlying metal wiring layers 38a and 38b. An interconnection layer made in contact with the plug is formed on the interlevel insulating layer to be connected with a ground or power supply bonding pad. As illustrated in FIG.6, the interlevel insulating layer 40 is locally etched to produce a groove 44 exposing a portion of the fuse link 36 by a conventional photolithographic technique. The diameter of the groove 44, which is preferably formed by etching, is preferably greater than that of the irradiated laser beam spot. In the present embodiment, the size of the groove 44 is approximately 7 x 7µm². After the formation of the groove 44, a blanket protection layer 42 such as a silicon nitride layer is deposited to a thickness of approximately 6,000 Å. The protection layer on the bonding pad is etched to expose the bonding pad.

After the completion of manufacturing processes, function tests may be performed. Assuming that the fuse link 36 is to be severed following the result of the tests or the selection of a desired function, an adjusted laser beam energy is irradiated to the fuse link 36 in such a manner that the laser beam spot with the diameter of 5 to 6µm is focused to the fuse link 36. The laser beam energy is absorbed by the fuse layer 32, allowing the fuse layer to be heated up and vaporized. As the fuse layer 32 is vaporized, the fuse link 36 is cut splashing the vaporized metal, i.e. TiN, debris around the fuse layer 32. The Si₃N₄ layer 42 serves to prevent interconnecting adjacent interconnection layers due to the metal debris and moisture is absorbed into the interlevel insulating layer 40.

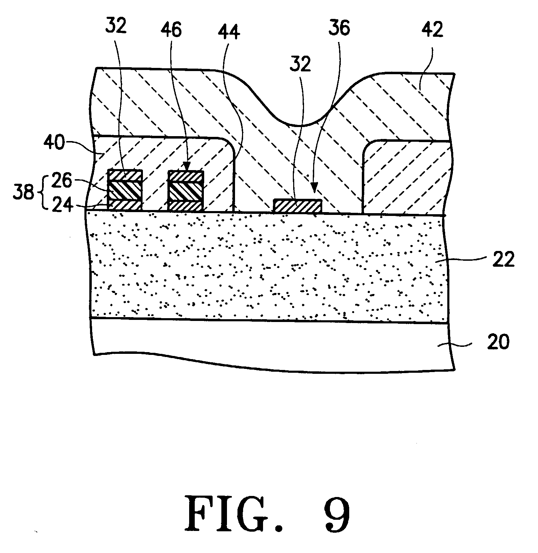

Fuses and a plurality of metal interconnects may be simultaneously formed on the insulating layer 22. It should be noted that the metal interconnects may be connected to the integrated circuit portion on the substrate 20 through via holes (not shown) formed in the insulating layer 22. Referring to FIG. 9, a plurality of metal interconnects, each of which is comprised of the metal wiring layer 38 and the overlying fuse layer 32, and the fuse link 36 of the TiN fuse layer 32 is formed on the insulating layer 22. Each metal wiring layer 38 is comprised of the barrier metal layer 24 and the overlying interconnection metal layer 26 as described above.

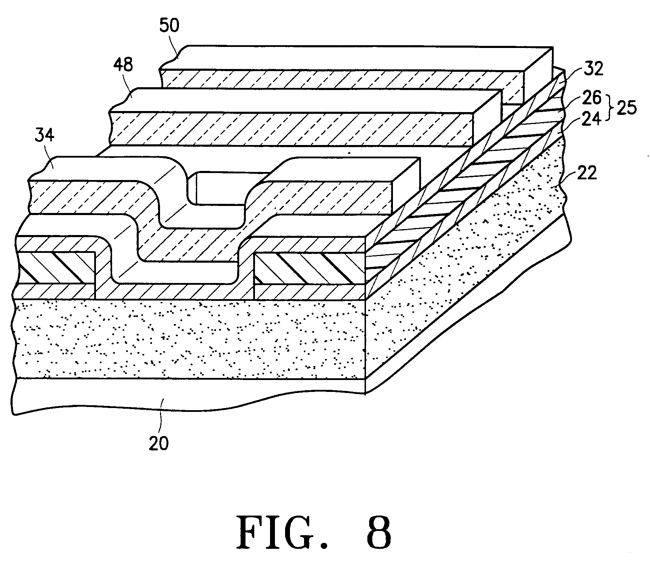

As shown in FIG. 8, the formation of the interconnects 46 and the fuse link 36 is accomplished by patterned photoresist mask 34, 48 and 50 on the TiN fuse layer 32 after the process of FIG.3 and then anisotropically etching. Even though the metal interconnects 46 are densely arranged at narrow spacings, since the TiN fuse layer 32 is a good absorber of impinged light during the patterning of the masks 48 and 50, light reflection into the photoresist from the TiN fuse layer 32 is highly reduced. Thus, the formation of fine metal interconnects 46 is possible.

After the formation of the metal interconnects 46 and fuse link 36, as described in connection with FIG. 6, an interlevel insulating layer 40 is formed. Then a groove 44 for irradiation of laser beam and via holes (not shown) for connecting with the metal interconnects 46 is formed in layer 40. Tungsten is filled in the via holes to form plugs as described above. On the interlevel insulating layer 40 is formed wire bonding pads (not shown) and uppermost level metal interconnects (not shown) connecting the pads to the underlying metal interconnects 46 through the tungsten plugs. As shown in FIG. 9, a blanket protection layer 42 of Si₃N₄ is deposited and the protection layer overlying the pads is etched to expose the pads.

It is a requirement of a preferred embodiment that the diameter of the groove 44 be greater than that of the laser beam. This means that when the laser beam is irradiating to cut fuse link 36, it is not irradiating the interlevel insulating layer 40. Thus, layer 40 is not subject to stress due to irradiation by the laser beam. If the interlevel insulating layer 40 is subject to such stress, the protection layer and interlevel insulating layer nearby the cut fuse link 36 have cracks. In which case if the cracks reach the metal interconnects 46 adjacent the cut fuse link 36, the presence of moisture causes the interconnect 46 to be corroded over a long time, thereby gradually deteriorating the electrical resistance of the interconnect 46. Such a successive corrosion results in an open interconnect. Thus, since the interlevel insulating layer 40 is not subject to the stress as mentioned above, the reliability of the metal interconnects can be enhanced.

It will be understood from the foregoing description, that, since the fuse link of the invention is composed of a barrier metal such as a TiN fuse layer formed on side walls of the end portions of opposing surfaces of two metal conductive layers of aluminum or aluminum alloy spaced apart from each other on an insulating layer, and an insulating layer between the end portions, the movement of electrons of aluminum atoms and the implantation of the aluminum can be reduced. This results in an improvement in the reliability and the life span of the metal wire including the fuse link.

In the case where densely spaced metal wires and a fuse link are formed on the insulating layer, since a barrier metal such as TiN fuse layer is formed on a metal layer of aluminium or aluminium alloy which intensively reflects an optical beam whereas the TiN barrier layer readily absorbs the optical beam, it is possible to form fine metal wires.

In the fuse link, the thin barrier TiN fuse layer absorbing the laser energy is heated by low laser energy, so that the fuse layer may be easily blown out. Such a low laser energy minimizes the stress on the peripheral elements. Also, since the diameter of the groove formed in the interlayer insulating layer is preferably at least larger than the diameter of the irradiating laser beam spot to which the fuse link is exposed, the interlayer insulating layer is not subjected to stress. Accordingly, fissures are less likely to be generated in the interlayer insulating layer, thereby improving the reliability and the life span of the metal wires.

It will be understood that whilst it is preferred the ends of interconnect layers 38a and 38b are directly opposite and in line with one another, this need not be the case. For example the layers 38a and 38b may be staggered or at an angle to one another. Also whilst the ends of layers 38a and 38b are preferably more or less perpendicular to the sides of 38a and 38b this is not essential. Clearly where the ends are directly opposite, layers 38a and 38b are in line with one another, and the ends of layers 38a and 38b are perpendicular to the sides, better coverage with fuse layer 32 is achievable.

## Claims

1. An integrated circuit comprising:
a first insulating layer formed on a semiconductor substrate;
at least one pair of metal wiring layers formed on said insulating layer and spaced apart; and
a metallic fuse layer formed to electrically connect said metal wiring layers, to define a fuse link severable by irradiation with a laser beam, in which the metallic fuse layer comprises a barrier metal less susceptible to electromigration than said metal wiring layers and/or more absorptive of irradiating laser beam energy than the metal wiring layers.

2. A process of manufacturing an integrated circuit comprising a plurality of metal interconnections on an insulating layer formed on a semiconductor substrate, in which at least one of said metal interconnections includes a fuse link severable by a laser beam, comprising the steps of :
forming a metal interconnection layer on a first insulating layer;
etching a selected portion of said metal interconnection layer for providing at least one pair of metal wiring layers being spaced apart;
forming a metallic fuse layer of a barrier metal on said etched portion to electrically connect the metal wiring layers; and
etching to form said metal interconnections including defining said fuse link;
in which the metallic fuse layer comprises a barrier metal less susceptible to electromigration than said wiring layers and/or more absorptive of irradiating laser beam energy than the metal wiring layers.

3. An integrated circuit or process according to claim 1 or 2, in which the metallic fuse layer is formed over end surfaces of the metal wiring layers.

4. An integrated circuit or process according to claim 3, in which the end surfaces of the metal wiring layers are opposite each other.

5. An integrated circuit or process according to claim 1, 2, 3 or 4, in which the metallic fuse layer is formed on the upper surfaces of the metal wiring layers.

6. An integrated circuit or process according to any preceding claim, in which the metallic fuse layer comprises a layer of TiN and/or TiW.

7. An integrated circuit according to any preceding claim, in which said two metal wiring layers each comprise, or consist of, a layer of pure aluminum or aluminum alloy.

8. An integrated circuit or process according to any preceding claim, in which said two metal wiring layers each is formed of a barrier metal layer and a metal interconnection sublayer formed on the barrier metal layer.

9. An integrated circuit or process according to claim 8, in which said barrier metal layer is a TiN layer, TiW layer or a Ti layer with a TiN layer formed on the Ti layer and/or said metal interconnection sublayer is an aluminium or aluminum alloy layer.

10. An integrated circuit or process according to any preceding claim, in which an interlevel second insulating layer is formed on said first insulating layer and on said fuse layer, and a groove is formed in said interlevel insulating layer exposing at least a portion of said fuse link.

11. An integrated circuit or process according to claim 10, in which the size of said groove is larger than the diameter of said laser beam.

12. An integrated circuit or process according to claim 10 or 11, in which a plurality of upper metal interconnections is formed on said interlevel second insulating layer for connecting to said underlying fuse layer, and a protection layer is formed covering said exposed fuse link and said upper metal interconnections.

13. An integrated circuit or process according to claim 12, in which said protection layer is a silicon-nitride layer.

14. An integrated circuit or process according to any preceding claim, in which a space separating the two metallic wiring layers is wider, in a direction generally perpendicular to a line drawn between the ends of the two metallic layers, than the width of the metallic fuse layer.

15. An integrated circuit or process according to any preceding claim, in which:
an integrated circuit portion is formed on a semiconductor substrate;
the first insulating layer is formed on said integrated circuit portion;
a plurality of metal wiring layers is formed at submicron or subhalf-micron spacing on said insulating layer for connecting to said integrated circuit portion, at least one pair forming said pair of metal wiring layers being spaced apart and having opposing ends for providing a fuse link severable by irradiation with a laser beam;
whereby the barrier metal is less reflective of optical light than the metal wiring layers.

16. An integrated circuit or a process according to any preceding claim in which at least one fuse link is severed.

17. A process of severing a fuse in an integrated circuit according to any preceding claim, comprising:
severing the fuse link with a laser beam of which the barrier metal is more absorptive than the metal wiring layers.

18. An integrated circuit as described herein with reference to and/or illustrated in figures 1 to 9.

19. A process of manufacturing an integrated circuit as described herein with reference to and/or as illustrated in figures 1 to 9.
